Europäisches Patentamt

European Patent Office

Office européen des brevets

(19)

(11) Publication number: **0 103 455**
A2

# (12) EUROPEAN PATENT APPLICATION

(21) Application number: 83305179.0

(22) Date of filing: 06.09.83

(51) Int. Cl.³: **G 05 F 1/56**, H 03 F 1/52

(30) Priority: 10.09.82 JP 157700/82
29.09.82 JP 172349/82

(43) Date of publication of application: 21.03.84
Bulletin 84/12

(84) Designated Contracting States: DE FR GB

(71) Applicant: FUJITSU LIMITED, 1015, Kamikodanaka Nakahara-ku, Kawasaki-shi Kanagawa 211 (JP)

(72) Inventor: Takagi, Masayuki, 2160-1, Suge Tama-ku, Kawasaki-shi Kanagawa 214 (JP)
Inventor: Komaju, Shigeru, 4160-50, Katsume-cho, Sendai-shi Kagoshima 895 (JP)
Inventor: Mugiya, Hiroshi, 6-12-8, Nagayama, Tama-shi Tokyo 206 (JP)

(74) Representative: Abbott, Leonard Charles et al, GILL JENNINGS & EVERY 53-64 Chancery Lane, London WC2A 1HN (GB)

(54) Power supply circuit.

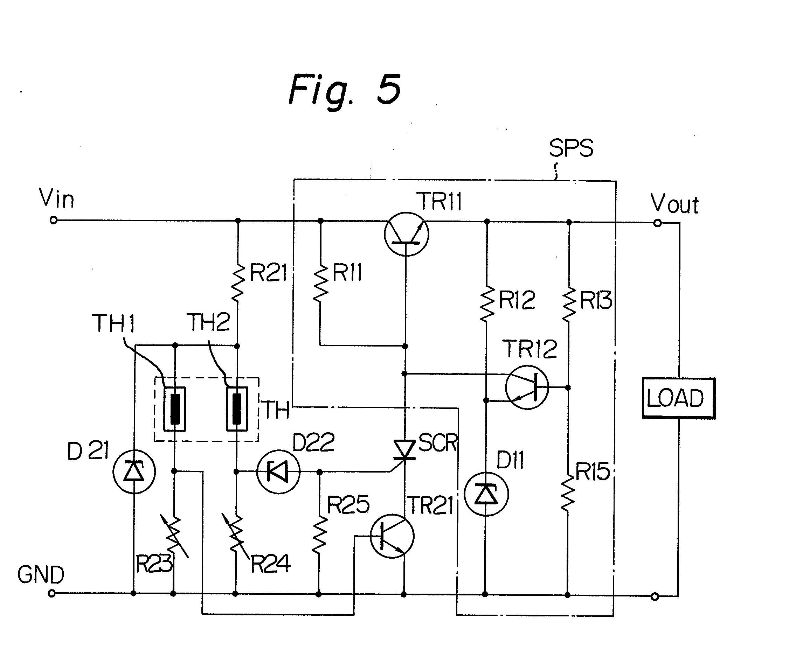

(57) A power supply having a voltage stabilising circuit includes voltage changing means responsive to an external control signal. In one embodiment, the external control signal ($V_{ext}$) is used to control a switching element (TR14) connected across a part of a voltage device (R13, R14) connected across the stabilised voltage supply, to vary the division ratio at a point in the voltage divider from which the stabilisation control voltage is derived. In another embodiment, the stabilised control voltage is cut off and restored by a switching circuit (SCR, TR21, Figure 5) in response to a control voltage rising above a first threshold and subsequently falling below a second threshold.

POWER SUPPLY CIRCUIT

The present invention relates to a power supply circuit which can stepwisely change its stabilized output voltage in response to an external control signal.

The power supply circuit in accordance with the present invention can be used, for example, for changing the voltage level applied to microwave amplifiers so as to change the amplification degree or for cutting off or restoring the stabilized output voltage applied to microwave amplifiers.

Stabilizing power supply circuits are used for a wide range of applications. In microwave applications, two stepwisely changeable stabilized power supplies are required: one        for changing an amplification degree of a microwave amplifier, in the case of two microwave amplifiers being operated in parallel and different voltage supplies being applied to one of the amplifiers so as to detect inoperation of the other; and the other, for cutting off the stabilized power supply to a microwave amplifier when the amplifier is in an abnormal state and restoring the power supply when the amplifier returns to normal.

There are several ways to provide these two stabilized power supplies.

A first way is to prepare two circuits, one providing a higher output voltage and the other providing a lower output voltage. As can be clearly understood, this has the disadvantages of higher manufacturing cost, greater size, and the need for a complicated switching circuit.

A second way is to install parallel resistors in the circuit and change these resistors in response to external conditions. This approach, however, has the disadvantages of a slight loss of stability in voltage potentials during transition and the need for a complicated switching circuit.

A third approach is to use a variable resistor in the circuit and to vary the resitance by a manual or automatic changing means. This, however, results in less operability and may entail use of a considerably complex device when automatic changing is desired.

The object of the present invention is to provide a power supply circuit which can provide a stabilized voltage which is reduced or cut off in response to an external control signal, by means of simple circuit technology.

In accordance with one aspect of the present invention, there is provided a power supply circuit comprising: an output transistor providing a stabilized output voltage; a control transistor controlling a base potential of the output transistor; an impedance means connected to a base of the control transistor such that the impedance means divides the stabilized voltage into parts, one of the said parts of the divided voltage being applied to the base of the control transistor; and characterized by a switching means which is turned on or off in response to an external control signal so as to vary a division ratio provided by the impedance means.

According to a further aspect of the present invention, there is provided a power supply circuit comprising: a stabilized voltage generating circuit including an output transistor stabilizing the voltage level; the circuit being characterized by a thyristor means connected to a base of the output transistor and which is triggered and becomes conductive when a first external control signal reaches a first predetermined value; and a switching means connected to the thyristor means in series and turned on when a second external control signal of a lower trigger level than the first external control signal reaches a second predetermined value; wherein the stabilized voltage is cut when the first external control signal reaches the first predetermined value and the stabilized voltage is restored when the second external control signal drops to the second predetermined value.

Other objects and features of the present invention will be clear with reference to the accompanying drawings, wherein:

Fig. 1 is a circuit diagram of a prior art stabilizing power supply;

Fig. 2 is a circuit diagram of a stabilizing power supply circuit in accordance with an embodiment of the present invention;

Figs. 3(A) to (C) are signal timing charts of the circuit shown in Fig. 2;

Fig. 4 shows an alternative circuit corresponding to the circuit shown in Fig. 2;

Fig. 5 is a circuit view of another embodiment in accordance with the present invention; and

Figs. 6(A) to (C) are signal timing charts of the circuit shown in Fig. 5.

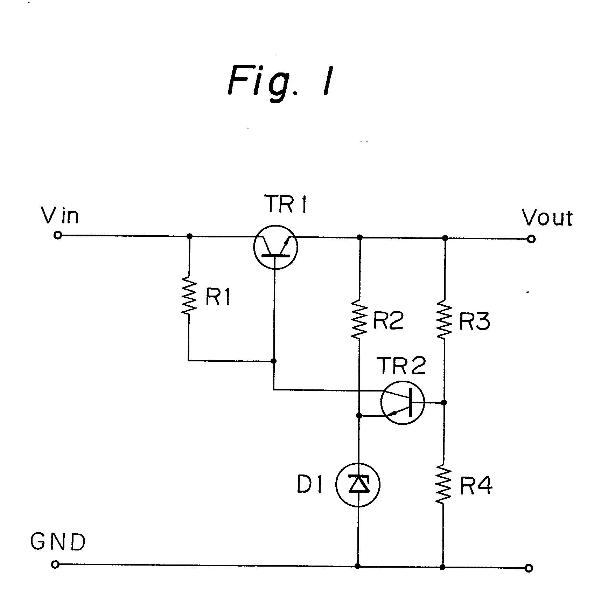

Before describing the preferred embodiment, a prior art stabilizing power supply circuit will be described for comparison. Figure 1 shows the prior art circuit. In Fig. 1, $V_{in}$ designates an input terminal, $V_{out}$ an output terminal, GND a grounded terminal, TR1 and TR2 transistors, D1 a zener diode, and R1, R2, R3, and R4 resistors.

In this circuit, when a positive voltage is applied between the input terminal $V_{in}$ and the ground termi-

nal GND, a positive voltage is applied to a base of the transistor TR1 through the resistor R1, and the transistor TR1 is turned on, whereby an output voltage is produced at the output terminal $V_{out}$.

Series-connected resistors R3 and R4 are inserted between the output terminal $V_{out}$ and the ground terminal GND. At a point between resistors R3 and R4 is connected a base of the transistor TR2. An emitter of the transistor TR2 is connected to the zener diode D1 for generating a reference voltage, and a collector thereof is connected to a base of the transistor TR1. Therefore, the transistor TR2 becomes active when the voltage (potential) at the above connecting point, i.e., the base potential of the transistor TR2, becomes greater than the emitter potential of the transistor TR2 and exceeds a predetermined value. When the transistor TR2 is further activated and the conductivity thereof is increased, the base potential of the transistor TR1 becomes low and the conductivity of transistor TR1 is reduced, whereby the output voltage at the output terminal $V_{out}$ can be maintained low.

On the other hand, when the potential between the base of transistor TR2 and the emitter thereof becomes smaller than a predetermined value, as opposed to the above, the transistor TR2 becomes inactive. When the conductivity of the transistor TR2 is reduced, the base potential of the transistor TR1 becomes high and the conductivity thereof becomes higher, whereby the output voltage at the output terminal $V_{out}$ can become high.

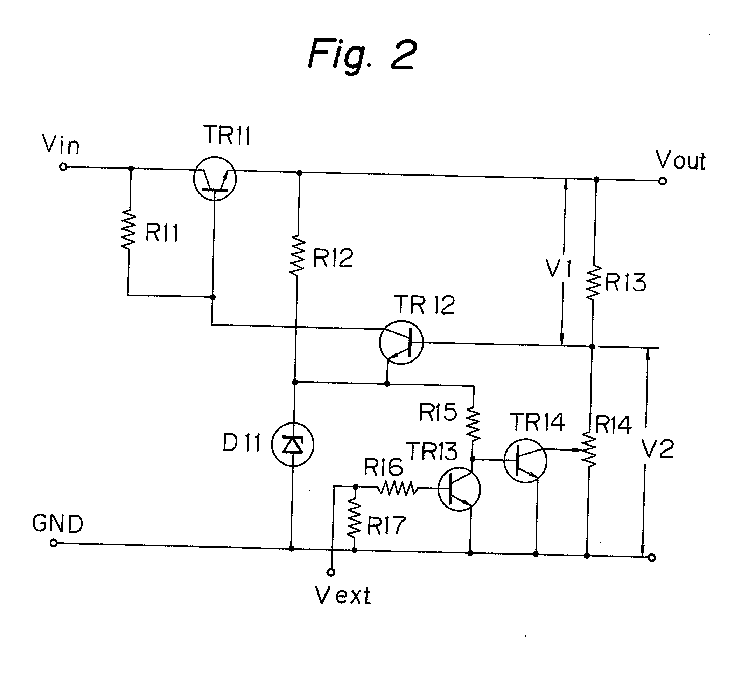

Figure 2 shows a power supply circuit in accordance with an embodiment of the present invention. In Fig. 2, $V_{in}$ indicates an input terminal, $V_{out}$ an output terminal, GND a grounded terminal, $V_{ext}$ an external control input terminal, TR11 to TR14 transistors, D11 a zener diode, R11 to R13 resistors, R14 a variable resistor, R15 to R17 resistors, V1 a voltage potential across resistor R13, and V2 a voltage potential across resistor R14. The

following relations exist:

$$V1 : V2 = R13 : R14,$$

$$\therefore V1 = V2 \frac{R13}{R14} .$$

$$V_{out} = V1 + V2 .$$

In this embodiment, the transistor TR14, whose collector is connected to a sliding terminal of the variable resistor R14, is turned on or off in response to a signal on the external control input terminal $V_{ext}$. The resistance between a base of the transistor TR12 and the grounded terminal GND is therefore changed, and the voltage V2 to be compared with a reference voltage produced by the zener diode D11 is changed. Thus, the operating point of the transistor TR12 is changed. Thereafter, the voltage at the output terminal $V_{out}$ may be changed to the high level or low level.

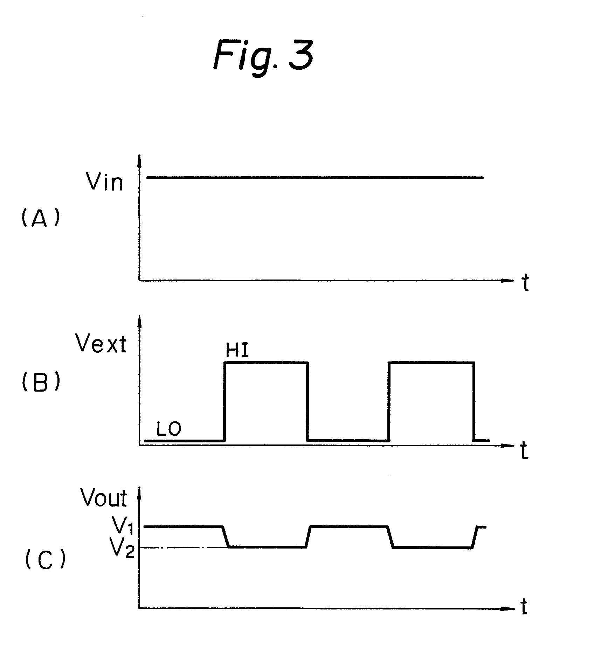

The output-voltage stabilizing operation in Fig. 2 is similar to that of the circuit in Fig. 1, so a detailed description will be omitted. Only the differences will be described below with reference to Figs. 3(A) to 3(C).

Figure 3(A) shows an input voltage ($V_{in}$) charac-teristic which is approximately constant independent of time (t). Figure 3(B) shows two conditions of the signal on the external control input terminal $V_{ext}$, i.e., a logical low (LO) condition and a logical high (HI) condition. Figure 3(C) shows the output voltage at the terminal $V_{out}$, which may change to high (V1) or low (V2) in response to the signal on the external control input terminal $V_{ext}$.

When the signal level on the external control input terminal $V_{ext}$ is zero (LO in Fig. 3(B)), a collector of the transistor TR13 has a high voltage applied through the resistor R15. However, the TR13 is still off. The transistor TR14 is then turned on, and the resistance of the variable resistor R14 is selected to that of the value set by means of the sliding terminal, which set value is smaller than entire resistance of variable resistor R14. Therefore, the circuit shown in Fig. 2 outputs a high-level stabilized voltage at the terminal $V_{out}$ ($V_1$ in Fig. 3(C)).

On the other hand, when the signal level on the external control input terminal $V_{ext}$ is high (HI in Fig. 3(B)), the transistor TR13 is turned on and the transistor TR14 is turned off, whereby the resistance of the variable resistor R14 is selected to its maximum value. Therefore, the resultant output voltage at the terminal $V_{out}$ is a low stabilized voltage potential ($V_2$ in Fig. 3(C)) smaller than that when the signal on the external control input terminal $V_{ext}$ is zero.

As mentioned above, the operating point of the transistor TR12, which controls the on or off state of the output transistor TR11 stabilizing the output voltage, can be changed by changing the effective/resistance of the variable resistor R14 connected to the base of the transistor TR12. The change of the variable resistor R14 is effected by turning on or turning off the transistor TR14, whose collector is connected to the sliding terminal of the resistor R14, in response to the condition of the external control signal. Accordingly, the circuit shown in Fig. 2 outputs a high stabilized voltage or low stabilized voltage in response to the condition of the external control signal.

The high stabilized voltage and the low stabilized voltage are defined by suitably setting circuit parameters. In particular, the high stabilized voltage is defined by arranging the position of the sliding terminal of the variable resistor R14.

Use of the circuit shown in Fig. 2 for a power supply of, for example, a microwave amplifier using a gallium-arsenic field effect transistor, enables the output signal level of the microwave amplifier to be easily changed from high to low, and vice versa, whereby the amplification degree of the microwave amplifier can be easily changed just by changing the level of the external control signal.

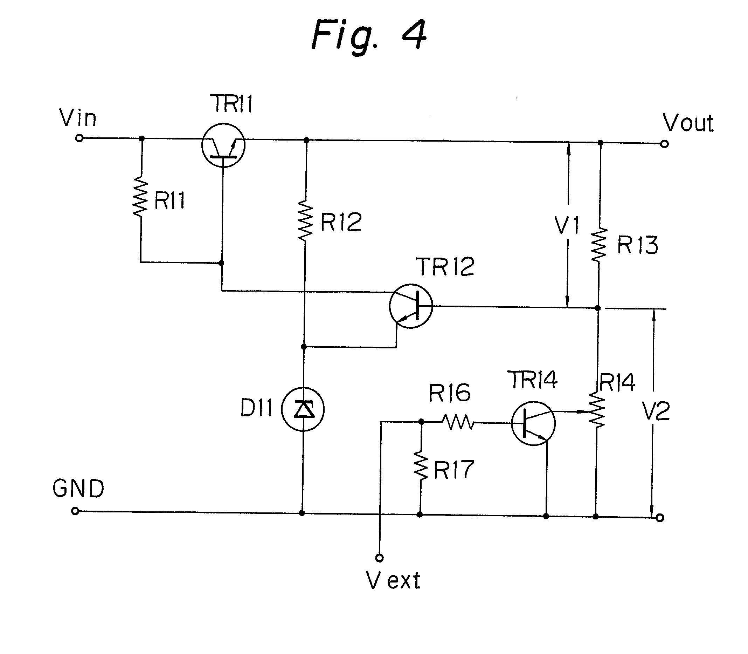

Fig. 4 shows a modified embodiment of the circuit shown in Fig. 2. In Fig. 4, as can be easily understood, the circuit responsive to the signal on the external control signal terminal $V_{ext}$ is simplified. The fundamental operation is similar to that of the circuit shown in Fig. 2, except that the polarity of the external control signal is reverse that of the circuit of Fig. 2.

Another embodiment will be described below with reference to Fig. 5. In Fig. 5, $V_{in}$ represents an input terminal, $V_{out}$ represents an output terminal, and a stabilizing power supply circuit SPS is similar to that in Fig. 1. The circuit shown in Fig. 5 further includes a thyristor SCR whose anode is connected to a base of the transistor TR11, a transistor TR21 whose collector is connected to a cathode of the thyristor and whose emitter is connected to a ground GND, a set of thermistors TH, incorporating a first thermistor TH1 and a second thermistor TH2, a zener diode D22 triggering the thyristor SCR in response to the second thermistor TH2, a zener diode D21 defining the voltage between the thermistor set TH and the ground GND, two variable resistors R23 and R24, and resistors R21 and R25.

The above circuit may, for example, be employed for a microwave amplifier as a stabilized power supply circuit which cuts off the power supply when the temperature detected by the thermistor set TH exceeds a predetermined value and which restores the power supply when the temperature falls below another predetermined value. In this case, the load in Fig. 5 corresponds to the microwave amplifier and the thermistor set TH is attached to the casing of the amplifier so as to detect the temperature of the amplifier.

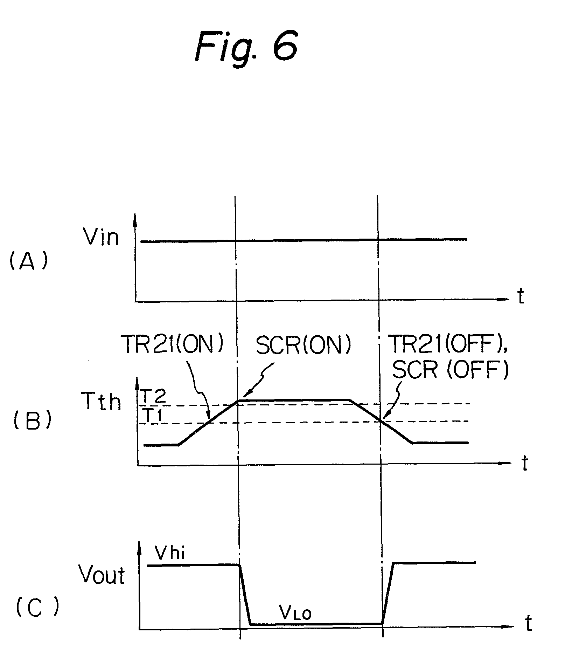

An approximately constant input voltage $V_{in}$ is applied between the terminal $V_{in}$ and the ground GND (Fig. 6(A)).

Referring to Fig. 6(B), a temperature T1 is defined as the threshold level which turns the transistor TR21 on or off. In other words, the base potential of the transistor TR21 is defined by means of the temperature T1 detected by the thermistor TH1 as well as circuit parameter of TH1 and R23. On the other hand, a temperature T2 is defined as the trigger level which ignites the thyristor SCR so as to make it conductive. In this embodiment, the temperature T2 is higher than the temperature T1. This is essential to obtain a deadband characteristic and to turn the thyristor SCR off.

In the initial condition, the temperature in the casing of the amplifier is lower than T1 and a rated output voltage ($V_{hi}$ in Fig. 6(C) is applied to the amplifier as a load. The thyristor SCR is thereby, inhibited, and the transistor TR21 is turned off.

When the temperature in the casing rises along with the operating time, the resistance of the thermistor set TH becomes low. When the temperature in the casing reaches T1, the transistor TR21 is turned on due to the voltage at the connecting points of the thermistor TH1 and the variable resistor R23 (Fig. 6(B)). When the temperature in the casing further increases and exceeds T2 (Fig. 6(B)), the thyristor SCR is triggered due to the voltage at the connecting point of the thermistor TH2 and the variable resistor R24. Then, the base potential of the transistor TR11 in stability power supply circuit SPS becomes low and the transistor TR11 is turned off, whereby the microwave amplifier is cut off from the power source ($V_{LO}$ in Fig. 6(C)).

With the power source cut off, the temperature in the casing may drop. When the temperature falls below T1 the transistor TR21 is turned off, whereby the thyristor SCR is turned off and the transistor TR11 is turned on.  Therefore, the power supply to the microwave amplifier is restored to the rated stabilized voltage level ($V_{hi}$ in Fig. 6(C)).

As mentioned above, the circuit shown in Fig. 5 provides a rated stabilized voltage or a low level voltage, which is substantially zero, depending on the load condition.  It should be noted that the above circuit has a deadband characteristic due to the thermistor conditions.  In other words, the circuit also provides two stabilized voltages in response to the conditions of the external control signals.

While the present invention has been described in reference to the above embodiments, it is not limited thereto except as defined in the claims.  For example, in Fig. 5, the thyristor SCR can be replaced by a triac. Also the thermistor can be replaced by another temperature sensor, such as a posistor (critical temperature resistor) which has a reverse characteristic to a thermistor.

- 10 -

CLAIMS

1.      A power supply circuit comprising: an output transistor (TR11) providing a stabilized output voltage; a control transistor (TR12) controlling a base potential of the output transistor; an impedance means (R13, R14) connected to a base of the control transistor such that the impedance means divides the stabilized voltage into parts, one of the said parts of the divided voltage being applied to the base of the control transistor; and characterized by a switching means (TR14) which is turned on or off in response to an external control signal ($V_{ext}$) so as to vary the division ratio provided by the impedance means.

2.      A power supply circuit according to claim 1, in which the impedance means includes a variable resistor (R14), a variable resistance terminal thereof being connected to the switching means (TR14).

3.      A power supply circuit according to claim 1 or 2, in which the switching means comprises a switching transistor (TR14) which can be turned on or off in response to  the external control signal ($V_{ext}$).

4.      A power supply circuit according to claim 1 or 2, in which the switching means comprises: a first switching transistor (TR13) which can be turned on or off in response to the external control signal and a second switching transistor (TR14) provided at an output point of the first switching transistor, the second switching transistor (TR14) changing the division ratio of the impedance means (R13, R14) in response to the operation of the first switching transistor.

5. A power supply circuit comprising: a stabilized voltage generating circuit (SPS) including an output transistor (TR11) stabilizing the voltage level; and characterized by a thyristor means (SCR) which is connected to a base of the output transistor (TR11) and which is triggered and becomes conductive when a first external control signal (from TH2) reaches a first predetermined value; and a switching means (TR21) which is connected to the thyristor means in series and which is turned on when a second external control signal (from TH1) of a lower trigger level than the first external control signal reaches a second predetermined value; wherein the stabilized voltage is cut when the first external control signal reaches the first predetermined value and the stabilized voltage is restored when the second external control signal drops to the second predetermined value.

6. A power supply circuit according to claim 5, in which said thyristor means is a thyristor.

7. A power supply circuit according to claim 5, in which said thyristor means is a triac.

8. A power supply circuit according to claim 6 or 7, in which said switching means is a switching transistor.

9. A power supply circuit according to any one of claims 5 to 8, in which the first external control signal is provided by a temperature detecting device (TH2) and in which the first predetermined value is provided by means of a zener diode (D22) to which a signal from the temperature detecting device is applied.

10. A power supply circuit according to claim 7, in which said second external control signal is provided by a temperature detecting device (TH1) and in which the second predetermined value is provided by means of a zener diode (D21) to which a signal from the temperature detecting device is applied.

11.    A power supply circuit according to claim 5, in which the circuit provides two stabilized voltage potentials stepwisely changeable depending on a deadband characteristic which is defined by two external control signals.

*Fig. 1*

# Fig. 2

# Fig. 3

(A) Vin — t

(B) Vext — HI / LO — t

(C) Vout — $V_1$ / $V_2$ — t

Fig. 4

Fig. 5

SPS

Vin

Vout

TR11

R21    R11

TH1    TH2

R12    R13

TH

TR12

D 21    D22    SCR

D11

R15

R25    TR21

R23    R24

GND

LOAD

5/6

0103455

## Fig. 6

(A)  Vin

(B)  Tth  T2  T1  — TR21(ON) | SCR(ON) | TR21(OFF), SCR (OFF)

(C)  Vout  Vhi  VLo